# EUROPEAN PATENT APPLICATION

(11) **EP 2 555 428 A1**
(43) Date of publication of application: **06.02.2013**
(21) Application number: 11759189.1
(22) Date of filing: 08.03.2011
(51) Int. Cl.: H03K 5/13

(54) **DELAY CONTROL DEVICE**

(30) Priority: 26.03.2010 JP 2010071495
(71) Applicant: Furukawa Electric Co., Ltd., Chiyoda-ku Tokyo 100-8322 (JP); Furukawa Automotive Systems Inc., Inukami-gun, Shiga 522-0242 (JP)
(72) Inventor: MUROFUSHI, Noritaka, Tokyo 100-8322 (JP); KAMIMURA, Kazutaka, Tokyo 100-8322 (JP); AOYAGI, Yasushi, Tokyo 100-8322 (JP)
(74) Representative: Grünberg, Thomas
(86) International application number: PCT/JP2011/055386
(87) International publication number: WO 2011/118381

(57) **Abstract**

A delay control device that controls a relative delay time between two signals and is easy to be miniaturized is provided. Signal routes 111 to 114 and signal routes 121 to 124 in a first signal route part 110 and a second signal route part 120 have different delay times. By selecting any one of the four signal routes 111 to 114 in the first signal route part 110 and any one of the four signal routes 121 to 124 in the second signal route part 120, it is possible to finely change a relative delay time between two input pulse signals.

## Description

### Technical Field

The present invention relates to a delay control device that controls a delay time between transmission and reception of a pulse signal at, for example, an UWB (Ultra Wideband) radar, in micro time units.

### Background Art

In the UWB radar device using a pulse signal, a target object within a predetermined distance range is detected by controlling a delay time from transmission of a pulse-like transmission signal to detection of a reception signal. Specifically, a predetermined distance, which is a detection range, is divided into a plurality of distance gates and, from the intensity of the reception signal at each of the distance gates, a distance gate where the target object is present is detected. To measure the intensity of the reception signal for each distance gate, it is required to control, with high accuracy, a relative delay time between the transmission signal and the reception signal corresponding to the distance gate.

As a conventional delay time control circuit controlling the delay time, an example described in Patent Document 1 is known. A delay circuit of Patent Document 1 is configured of, as shown in FIG. 10, an NMOS transistor TRn using a MOS-type transistor and a capacitor C connected in series to this NMOS transistor TRn, and outputs an input signal as being delayed by a predetermined time. A delay circuit 900 has an input side and an output side connected to a NOT gate NOTin and a NOT gate NOTout, respectively.

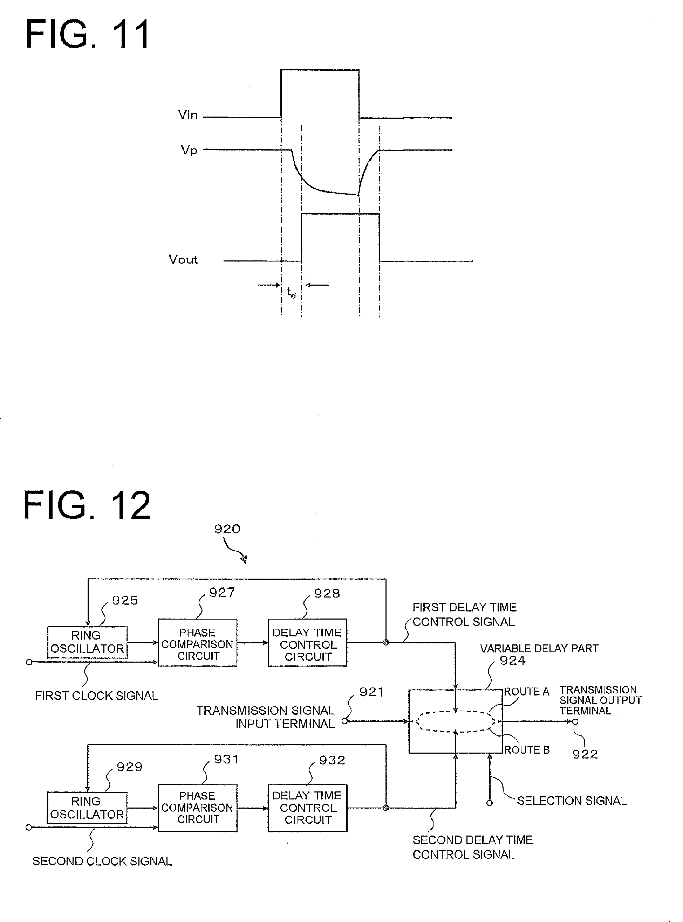

The NMOS transistor TRn has its drain terminal connected to an input/output signal side coupling the NOT gate NOTin and the NOT gate NOTout together, its source terminal connected to the ground on a power supply side via the capacitor C, and its gate terminal fixed to a power supply voltage (Vcc) and set always at an ON state. Here, the NMOS transistor TRn is used as a variable resistance R capable of controlling a voltage between the gate and the source. By the resistance value of this variable resistance R and the capacitance value of the capacitor C, a delay amount can be determined. When a pulse voltage Vin as shown in FIG. 11 is inputted, a voltage Vp at a connecting point has an integral waveform, and a pulse voltage Vout obtained by delaying the input pulse voltage by a delay time td given by a time constant of CR is outputted.

Also, as another conventional delay circuit, the one described in Patent Document 2 is also known. A variable delay circuit described in Patent Document 2 includes, as shown in FIG. 12, two routes A and B sending a signal inputted at an input terminal 921 to an output terminal 922, a variable delay part 924 including a selecting part switching between the routes A and B with a select signal, ring oscillators 925 and 929 having an oscillation cycle x times and y times of at least part of the delay time of the respective routes A and B, phase comparison circuits 927 and 931 comparing in phase between a first clock signal and an output from the ring oscillator 925 and between a second clock signal and an output from the ring oscillator 929, and delay time control circuits 928 and 932 controlling the oscillation cycles of the ring oscillators 925 and 929 so that the oscillation cycles of the ring oscillators 925 and 929 are equal to the cycles of the first clock signal and the second clock signal from the phase comparison results at the phase comparison circuits 927 and 931 and also controlling delay times of the routes A and B.

The route A has n variable delay elements Ta interposed therein, and the route B has m variable delay elements Tb interposed therein. The ring oscillator 925 is configured to have x' variable delay elements Ta which are the same as those of the route A connected in series, inverting its output for feedback to an input side. The delay time control circuit 928 simultaneously controls delay times of the variable delay elements Ta of the route A and each of the variable delay elements Ta of the ring oscillator 925. The ring oscillator 929 is configured to have y' (when the cycle of the first clock signal is taken as T1 and the cycle of the second clock signal is taken as T2, T1×x' /n≠T2×y' /m) variable delay elements Tb which are the same as those of the route B connected in series, inverting its output for feedback to an input side. The delay time control circuit 932 simultaneously controls delay times of the variable delay elements Tb of the route B and each of the variable delay elements Tb of the ring oscillator 929. In the above-configured variable delay circuit 920, the delay time of the first route A is T1/y and the delay time of the second route B is T2/y, and any desired resolution can be selected by defining appropriate values of T1, T2, x, and y.

The delay circuit 900 described in Patent Document 1 and the variable delay circuit 920 described in Patent Document 2 are configured to provide a delay time to one input signal. To use these delay circuits for a radar device to measure a distance to a target object or the like, it is required to configure the circuit so that the delay time is provided to at least one of the transmission signal and the reception signal, thereby allowing a relative delay time between the transmission signal and the reception signal to be controlled.

### Prior Art Document

### Patent Documents

Patent Document 1: Japanese Patent Application Laid-open No. H07(1995)-115351
Patent Document 2: Japanese Patent Application Laid-open No. H09(1997)-93098

### Summary of the Invention

### Problem to be Solved by the Invention

However, in the delay circuit described in Patent Document 1, all circuits are fixed at the time of mounting, and it is therefore difficult to change the inside of the circuits after mounting to readjust the delay time. For this reason, this delay circuit cannot be used for a radar device that is required to sequentially change the relative delay time between the transmission signal and the reception signal. Moreover, in the variably delay circuit described in Patent Document 2, although it is possible to change the delay time after mounting, the size of the variable delay circuit is large, and a large installation area is required. Also, there is a problem of high cost. Therefore, this delay circuit cannot be used for a UWB radar that is required to be miniaturized.

The present invention was made in view of the problems described above, and has an object of providing a delay control device that controls a relative delay time between two signals and is easy to be miniaturized.

### Means for Solving the Problem

To solve the problems described above, a first aspect of a delay control device according to the present invention is directed to a delay control device that receiving inputs of a first input pulse signal and a second input pulse signal and outputting a first output pulse signal and a second output pulse signal having a relative delay time near a predetermined target value, the device including: a first input end receiving the input of the first input pulse signal; a second input end receiving the input of the second input pulse signal; a first output end outputting the first output pulse signal; a second output end outputting the second output pulse signal; a first signal route part having two or more signal routes with different delay times; a second signal route part having two or more signal routes with different delay times; a first switch having one connection end formed of two or more terminals connecting one end of each of two or more signal routes of the first signal route part and another connection end formed of one terminal; a second switch having one connection end formed of two or more terminals connecting one end of each of two or more signal routes of the second signal route part and another connection end formed of one terminal; and a control part outputting a control signal to the first switch and the second switch so that a relative delay time between the first output pulse signal and the second output pulse signal is near the target value, the control signal for selecting any one of the terminals of the one connection end of the first switch and connecting the selected terminal to the terminal of the other connection end of the first switch and for selecting any one of the terminals of the one connection end of the second switch and connecting the selected terminal to the terminal of the other connection end of the second switch, wherein the first signal route part and the first switch are connected between the first input end and the first output end, and the second signal route part and the second switch are connected between the second input end and the second output end.

According to the first aspect of the present invention, a relative delay time between two signals can be controlled with high accuracy.

In another aspect of the delay control device of the present invention, the signal routes of the first signal route part and/or the second signal route part are configured so that the delay times are different among the signal routes by providing 0 or one or more NOT gates cascade-connected to each other on the signal routes.

In still another aspect of the delay control device of the present invention, the control part connects the first switch to one of signal routes passing through 0 or an even number of NOT gates or one of signal routes passing through an odd number of NOT gates in the first signal route part according to whether the first input pulse signal is a non-inversion signal or an inversion signal, and connects the second switch to one of signal routes passing through 0 or an even number of NOT gates or one of signal routes passing through an odd number of NOT gates in the second signal route part according to whether the second input pulse signal is a non-inversion signal or an inversion signal.

In still another aspect of the delay control device of the present invention, two or more signal routes of the first signal route part each have an output side connected to the one connection end of the first switch and an input side merged to be connected to the first input end, the other connection end of the first switch is connected to the first output end, two or more signal routes of the second signal route part each have an output side connected to the one connection end of the second switch and an input side merged to be connected to the second input end, and the other connection end of the second switch is connected to the second output end.

In still another aspect of the delay control device of the present invention, the other connection end of the first switch is connected to the first input end, two or more signal routes of the first signal route part each have an input side connected to the one connection end of the first switch and an output side merged to be connected to the first output end, the other connection end of the second switch is connected to the second input end, and two or more signal routes of the second signal route part each have an input side connected to the one connection end of the second switch and an output side merged to be connected to the second output end.

In still another aspect of the delay control device of the present invention, two said first switches and two said second switches are provided and connected to an input side and an output side of the first signal route part and an input side and an output side of the second signal route part, the other connection end of the first switch connected to the input side of the first signal route part is connected to the first input end and the other connection end of the first switch connected to the output side of the first signal route part is connected to the first output end, and the other connection end of the second switch connected to the input side of the second signal route part is connected to the second input end and the other connection end of the second switch connected to the output side of the second signal route part is connected to the second output end.

In still another aspect of the delay control device of the present invention, the first input pulse signal is a non-inversion signal, and the first signal route part is configured so that the two or more signal routes each pass through a different number, which is 0 or an even number, of NOT gates.

In still another aspect of the delay control device of the present invention, the first input pulse signal is an inversion signal, and the first signal route part is configured so that the two or more signal routes each pass through a different odd number of NOT gates.

In still another aspect of the delay control device of the present invention, the first input pulse signal is an non-inversion signal or an inversion signal, the first signal route part has a first sub signal route part formed of two or more signal routes each passing through a different number, which is 0 or an even number, of NOT gates and a second sub signal route part formed of two or more signal routes each passing through a different odd number of NOT gates, and the control part outputs a control signal for selecting one of the signal routes in the first sub signal route part to the first switch when the first input pulse signal is a non-inversion signal, and outputs a control signal for selecting one of the signal routes in the second sub signal route part to the first switch when the first input pulse signal is an inversion signal.

In still another aspect of the delay control device of the present invention, the second input pulse signal is a non-inversion signal, and the second signal route part is configured so that the two or more signal routes each pass through a different number, which is 0 or an even number, of NOT gates.

In still another aspect of the delay control device of the present invention, the second input pulse signal is an inversion signal, and the second signal route part is configured so that the two or more signal routes each pass through a different odd number of NOT gates.

In still another aspect of the delay control device of the present invention, the second input pulse signal is an non-inversion signal or an inversion signal, the second signal route part has a third sub signal route part formed of two or more signal routes each passing through a different number, that is 0 or an even number, of NOT gates and a fourth sub signal route part formed of two or more signal routes each passing through a different odd number of NOT gates, and the control part outputs a control signal for selecting one of the signal routes in the third sub signal route part to the second switch when the second input pulse signal is a non-inversion signal, and outputs a control signal for selecting one of the signal routes in the fourth sub signal route part to the second switch when the second input pulse signal is an inversion signal.

In still another aspect of the delay control device of the present invention, the first input pulse signal is a non-inversion signal, and the first signal route part has a first main signal route having N₁ (N₁ is an even number equal to or larger than 2) NOT gates cascade-connected to each other and a branch signal route branched from the first main signal route immediately before an M₁-th (M₁=1, 3, ..., N₁-1) NOT gate of the N₁ NOT gates or a branch signal route merged to the first main signal route immediately after an L₁-th (L₁=2, 4, ..., N₁) NOT gate of the N₁ NOT gates.

In still another aspect of the delay control device of the present invention, the first input pulse signal is an inversion signal, and the first signal route part has a second main signal route having N₂ (N₂ is an odd number equal to or larger than 3) NOT gates cascade-connected to each other and a branch signal route branched from the second main signal route immediately after an M₂-th (M₂=1, 3, ..., N₂-2) NOT gate of the N₂ NOT gates or a branch signal route merged to the second main signal route immediately after an L₂-th (L₂=2, 4, ..., N₂-1) NOT gate of the N₂ NOT gates.

In still another aspect of the delay control device of the present invention, the first input pulse signal is a non-inversion signal or an inversion signal, the first signal route part has (1) a first sub signal route part having a first main signal route having N₁ (N₁ is an even number equal to or larger than 2) NOT gates cascade-connected to each other, and a branch signal route branched from the first main signal route immediately before an M₁-th (M₁=1, 3, ..., N₁-1 ) NOT gate of the N₁ NOT gates or a branch signal route merged to the first main signal route immediately after an L₁-th (L₁=2, 4, ..., N₁) NOT gate of the N₁ NOT gates and (2) a second sub signal route part having a second main signal route having N₂ (N₂ is an odd number equal to or larger than 3) NOT gates cascade-connected to each other, and a branch signal route branched from the second main signal route immediately after an M₂-th (M₂=1, 3, ..., N₂-2) NOT gate of the N₂ NOT gates or a branch signal route merged to the second main signal route immediately after an L₂-th (L₂=2, 4, ..., N₂-1) NOT gate of the N₂ NOT gates, and the control part outputs a control signal for selecting one of the signal routes in the first sub signal route part to the first switch when the first input pulse signal is a non-inversion signal, and outputs a control signal for selecting one of the signal routes in the second sub signal route part to the first switch when the first input pulse signal is an inversion signal.

In still another aspect of the delay control device of the present invention, the second input pulse signal is a non-inversion signal, and the second signal route part has a third main signal route having N₃ (N₃ is an even number equal to or larger than 2) NOT gates cascade-connected to each other, and a branch signal route branched from the third main signal route immediately before an M₃-th (M₃=1, 3, ..., N₃-1) NOT gate of the N₃ NOT gates or a branch signal route merged to the third main signal route immediately after an L₃-th (L₃=2, 4, ..., N₃) NOT gate of the N₃ NOT gates.

In still another aspect of the delay control device of the present invention, the second input pulse signal is an inversion signal, and the second signal route part has a fourth main signal route having N₄ (N₄ is an odd number equal to or larger than 3) NOT gates cascade-connected to each other, and a branch signal route branched from the fourth main signal route immediately after an M₄-th (M₄=1, 3, ..., N₄-2) NOT gate of the N₄ NOT gates or a branch signal route merged to the fourth main signal route immediately after an L₄-th (L₄=2, 4, ..., N₄-1) NOT gate of the N₄ NOT gates.

In still another aspect of the delay control device of the present invention, the second input pulse signal is a non-inversion signal or an inversion signal, the second signal route part has (1) a third sub signal route part having a third main signal route having N₃ (N₃ is an even number equal to or larger than 2) NOT gates cascade-connected to each other, and a branch signal route branched from the third main signal route immediately before an M₃-th (M₃=1, 3, ... , N₃-1) NOT gate of the N₃ NOT gates or a branch signal route merged to the third main signal route immediately after an L₃-th (L₃=2, 4, ..., N₃) NOT gate of the N₃ NOT gates and (2) a fourth sub signal route part having a fourth main signal route having N₄ (N₄ is an odd number equal to or larger than 3) NOT gates cascade-connected to each other, and a branch signal route branched from the fourth main signal route immediately after an M₄-th (M₄=1, 3, ..., N₄-2) NOT gate of the N₄ NOT gates or a branch signal route merged to the fourth main signal route immediately after an L₄-th (L₄=2, 4, ..., N₄-1) NOT gate of the N₄ NOT gates, and the control part outputs a control signal for selecting one of the signal routes in the third sub signal route part to the second switch when the second input pulse signal is a non-inversion signal, and outputs a control signal for selecting one of the signal routes in the fourth sub signal route part to the second switch when the second input pulse signal is an inversion signal.

In still another aspect of the delay control device of the present invention, the first input pulse signal is a non-inversion signal or an inversion signal, the first signal route part has a first main signal route having a plurality of NOT gates cascade-connected to each other and also has (1) a first sub signal route part formed of a plurality of signal routes each passing through a different even number of NOT gates from an input side of the first main signal route to the one connection end of the first switch by being branched midway from the first main signal route or passing through the entire first main signal route, and a second sub signal route part formed of a plurality of signal routes each passing through a different odd number of NOT gates from the input side of the first main signal route to the one connection end of the first switch by being branched midway from the first main signal route or passing through the entire first main signal route or (2) a first sub signal route part formed of a plurality of signal routes each passing through a different even number of NOT gates from the one connection end of the first switch to an output side of the first main signal route by being merged midway to the first main signal route or passing through the entire first main signal route, and a second sub signal route part formed of a plurality of signal routes each passing through a different odd number of NOT gates from the one connection end of the first switch to the output side of the first main signal route by being merged midway to the first main signal route or passing through the entire first main signal route, and the control part outputs a control signal for selecting one of the signal routes in the first sub signal route part to the first switch when the first input pulse signal is a non-inversion signal, and outputs a control signal for selecting one of the signal routes in the second sub signal route part to the first switch when the first input pulse signal is an inversion signal.

In still another aspect of the delay control device of the present invention, the second input pulse signal is a non-inversion signal or an inversion signal, the second signal route part has a second main signal route having a plurality of NOT gates cascade-connected to each other and also has (1) a third sub signal route part formed of a plurality of signal routes each passing through a different even number of NOT gates from an input side of the second main signal route to the one connection end of the second switch by being branched midway from the second main signal route or passing through the entire second main signal route, and a fourth sub signal route part formed of a plurality of signal routes each passing through a different odd number of NOT gates from the input side of the second main signal route to the one connection end of the second switch by being branched midway from the second main signal route or passing through the entire second main signal route or (2) a third sub signal route part formed of a plurality of signal routes each passing through a different even number of NOT gates from the one connection end of the second switch to an output side of the second main signal route by being merged midway to the second main signal route or passing through the entire second main signal route, and a fourth sub signal route part formed of a plurality of signal routes each passing through a different odd number of NOT gates from the one connection end of the second switch to the output side of the second main signal route by being merged midway to the second main signal route or passing through the entire second main signal route, and the control part outputs a control signal for selecting one of the signal routes in the third sub signal route part to the second switch when the second input pulse signal is a non-inversion signal, and outputs a control signal for selecting one of the signal routes in the fourth sub signal route part to the second switch when the second input pulse signal is an inversion signal.

In still another aspect of the delay control device of the present invention, the first signal route part, the second signal route part, the first switch, and the second switch, and the control part are configured in a PLD (Programmable Logic Device).

### Effect of the Invention

According to the present invention, aminiaturized delay control device capable of controlling a relative delay time between two signals can be provided.

### Brief Description of the Drawings

FIG. 1 is a block diagram showing the structure of a delay control device according to a first embodiment of the present invention.
FIG. 2 is a block diagram showing an example of a system configured so that a relative delay time between two signals can be adjusted from outside by using the delay control device of the first embodiment.
FIG. 3 is a graph in which an example of the delay time by the delay control device of the first embodiment is plotted.
FIG. 4 is a block diagram showing the structure of a delay control device according to a second embodiment of the present invention.
FIG. 5 is a block diagram showing the structure of a delay control device according to a third embodiment of the present invention.
FIG. 6 is a block diagram showing the structure of a delay control device according to a fourth embodiment of the present invention.
FIG. 7 is a graph in which an example of the delay time by the delay control device of the fourth embodiment is plotted.
FIG. 8 is a block diagram showing the structure of a delay control device according to a fifth embodiment of the present invention.
FIG. 9 is a block diagram showing the structure of a delay control device according to a sixth embodiment of the present invention.
FIG. 10 is a circuit diagram showing a conventional delay circuit.
FIG. 11 is a graph showing changes of signals with time by the conventional delay circuit.
FIG. 12 is a block diagram showing the structure of a conventional variable delay circuit.
FIG. 13 is a block diagram showing the structure of a delay control device according to a seventh embodiment of the present invention.
FIG. 14 is a block diagram showing the structure of a delay control device according to an eighth embodiment of the present invention.
FIG. 15 is a block diagram showing the structure of a delay control device according to a ninth embodiment of the present invention.

### Description of Embodiments

Delay control devices according to preferred embodiments of the present invention are described in detail below with reference to the drawings. For simplification of the drawings and description, components having the same function are provided with the same reference numeral.

### (First Embodiment)

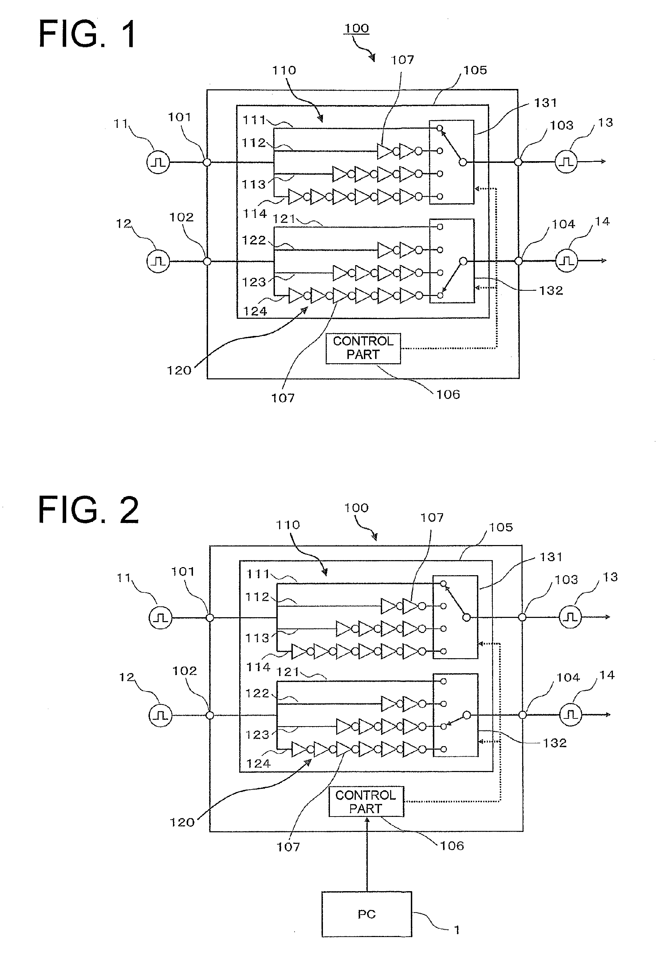

A delay control device according to a first embodiment of the present invention is described below using FIGs. 1 and 2. FIG. 1 is a block diagram showing the structure of a delay control device 100 of the present embodiment, and FIG. 2 is a block diagram showing an example of a system configured so that a relative delay time between two signals can be adjusted from outside by using the delay control device 100 of the present embodiment. The delay control device 100 of the present embodiment includes a first input end 101 and a second input end 102 each for receiving an input of an input pulse signal from outside, a delay control circuit 105 delaying two input signals inputted from the first input end 101 and the second input end 102 each by a predetermined delay time for output, a control part 106 outputting a control signal for controlling the delay time to the delay control circuit 105, and a first output end 103 and a second output end 104 each for outputting an output signal from the delay control circuit 105 to the outside.

In the delay control device 100 of the present embodiment, a first input pulse signal 11 and a second input pulse signal 12 are inputted as input signals to the first input end 101 and the second input end 102, respectively, and a first output pulse signal 13 and a second output pulse signal 14 are outputted as output signals from the first output end 103 and the second output end 104, respectively.
The first input pulse signal 11 and the second input pulse signal 12 each can be a pulse signal having a pulse width of, for example, 1 ns.

In the system shown in FIG. 2, the system is configured to allow a relative delay time between the first output pulse signal 13 and the second output pulse signal 14 to be changed from an external computing device (in FIG. 2, a personal computer (PC)) 1 connected to the delay control device 100. That is, a target value of the delay time is inputted from the computing device 1 to the control part 106, and the control part 106 controls the delay control circuit 105 to select a value near the target value (preferably a value within a range from the target value to the third nearest value, further preferably a value within a range from the target value to the second nearest value, and still further preferably the most nearest value (including a value that matches the target value), the same applies hereafter) as a relative delay time between the first output pulse signal 13 and the second output pulse signal 14.

The delay control circuit 105 includes two signal route parts, that is, a first signal route part 110 and a second signal route part 120, and two output side switches, that is, a first output side switch 131 and a second output side switch 132, correspondingly to two input pulse signals 11 and 12. The first input pulse signal 11 is inputted from the first input end 101 to the first signal route part 110, and is further outputted from the first output end 103 via the first output side switch 131. Similarly, the second input pulse signal 12 is inputted from the second input end 102 to the second signal route part 120, and is further outputted from the second output end 104 via the second output side switch 132.

The first signal route part 110 includes four signal routes 111 to 114 obtained by branching a route from the first input end 101 into four, and their output sides are connected to the first output side switch 131. In each of the signal routes 111 to 114, a different number, which is 0 or an even number, of NOT gates 107 are cascade-connected to each other. Similarly, the second signal route part 120 includes four signal routes 121 to 124 obtained by branching a route from the second input end 102 into four, and their output sides are connected to the second output side switch 132. In each of the signal routes 121 to 124, a different number, which is 0 or an even number, of NOT gates 107 are cascade-connected to each other.

The present embodiment is configured such that the signal routes 111 to 114 and the signal routes 121 to 124 each include 0 or an even number of NOT gates 107 in order to prevent inversion of the input pulse signal. One NOT gate 107 inverts the input signal, and outputs the signal as being delayed by a predetermined time. Thus, the present embodiment is configured such that the input pulse signals 11 and 12 each passes through 0 or an even number of NOT gates 107. In FIG. 1, the signal routes 111 to 114 have 0, two, four, and six NOT gates 107, respectively, cascade-connected to each other, and the signal routes 121 to 124 have 0, two, four, and six NOT gates 107, respectively, cascade-connected to each other.

The first output side switch 131 selects any one of terminals connected to four signal routes 111 to 114 and connects the selected terminal to a terminal connected to the first output end 103. With this, the first input pulse signal 11 is outputted from the first input end 101 via any one of the signal routes 111 to 114 to the first output end 103. Also, the second output side switch 132 selects any one of terminals connected to four signal routes 121 to 124 and connects the selected terminal to a terminal connected to the second output end 104. With this, the second input pulse signal 12 is outputted from the second input end 102 via any one of the signal routes 121 to 124 to the second output end 104.

The NOT gates 107 cascade-connected inside the first signal route part 110 and the second signal route part 120 each delay (gate-delay) a signal passing therethrough by a predetermined delay time for output. Therefore, by changing the number of NOT gates 107 cascade-connected in the signal routes 111 to 114 and 121 to 124, the structure can be made such that the signal routes 111 to 114 and 121 to 124 have different delay times.

Also, the delay time provided by route selection from the signal routes 111 to 114 and 121 to 124 is influenced not only by the number of NOT gates 107 but also by a wiring position where each signal route is formed, and others. As a result, even among signal routes having the same number of NOT gates 107, delay times are different due to different wiring routes. In the delay control device 100 of the present embodiment, by combining any one of the four signal routes 111 to 114 of the first signal route part 110 having different delay times and any one of the four signal routes 121 to 124 of the second signal route part 120 having different delay times, the relative delay time between two input pulse signals can be finely changed.

For example, upon an input of a target value of the delay time from the external computing device 1, the control part 106 performs control so that switching is appropriately made between the first output side switch 131 and the second output side switch 132. With the control part 106 appropriately switching between the first output side switch 131 and the second output side switch 132, a signal route of the first signal route part 110 through which the first input pulse signal 11 passes and a signal route of the second signal route part 120 through which the second input pulse signal 12 passes are selected. As a result, the delay time when the first input pulse signal 11 passes through the first signal route part 110 and the delay time when the second input pulse signal 12 passes through the second signal route part 120 are each changed. With this, a value near the target value described above can be selected as a relative delay time between the first output pulse signal 13 and the second output pulse signal 14.

Note that while the target value of the delay time is set at the control part 106 from the external computing device 1 in FIG. 2, if a procedure of setting a target value of the delay time or the like is defined in advance, it is also possible to allow programming of the target value setting procedure to be provided to the control part 106 in advance.

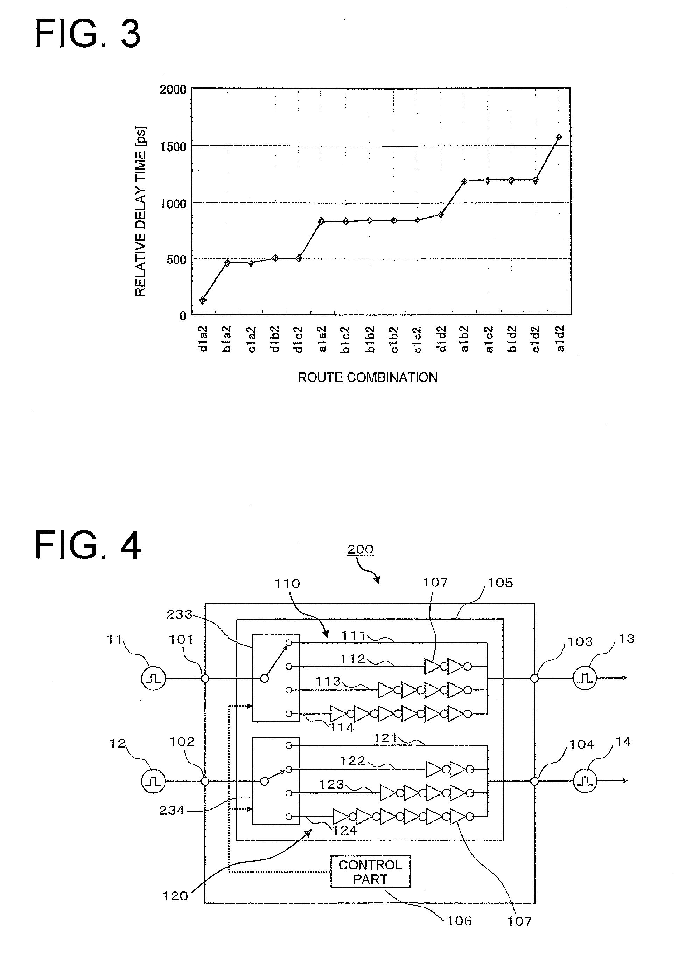

Since the delay control device 100 of the present embodiment is configured to include, as shown in FIG. 1, the first signal route part 110 having the four signal routes 111 to 114 and the second signal route part 120 having the four signal routes 121 to 124, the number of combinations of signal routes selectable at the first output side switch 131 and the second output side switch 132 are 4x4=16. An example of relative delay times each between the first output pulse signal 13 and the second output pulse signal 14 with respect to each combination is shown in Table 1. Also, FIG. 3 shows the results shown in Table 1 plotted in the order in which the combination with the shortest delay time comes first.

**Table 1**

| First signal route part | Second signal route part | Relative delay [ps] |
|---|---|---|
| Signal route 114 | Signal route 121 | 130 |
| Signal route 112 | Signal route 121 | 460 |
| Signal route 113 | Signal route 121 | 460 |
| Signal route 114 | Signal route 122 | 500 |
| Signal route 114 | Signal route 123 | 500 |
| Signal route 111 | Signal route 121 | 830 |
| Signal route 112 | Signal route 123 | 830 |
| Signal route 112 | Signal route 122 | 840 |
| Signal route 113 | Signal route 122 | 840 |
| Signal route 113 | Signal route 123 | 840 |
| Signal route 114 | Signal route 124 | 880 |
| Signal route 111 | Signal route 122 | 1176 |
| Signal route 111 | Signal route 123 | 1190 |
| Signal route 112 | Signal route 124 | 1190 |
| Signal route 113 | Signal route 124 | 1190 |
| Signal route 111 | Signal route 124 | 1570 |

As described above, the delay control device 100 of the present embodiment selects one signal route each from the first signal route part 110 and the second signal route part 120 each having two or more signal routes, thereby finely controlling a relative delay time between two signals. As a result, a value near the predetermined target value can be selected as a relative delay time between the first output pulse signal 13 and the second output pulse signal 14.

Also, the delay control device 100 of the present embodiment can be achieved by using, for example, a PLD (Programmable Logic Device). With the use of a PLD, the delay control device 100 can be miniaturized to achieve low cost. According to the delay control device 100 of the present embodiment, as shown in Table 1 and FIG. 3, the delay time can be controlled on the order of ps.

Note that while the first signal route part 110 and the second signal route part 120 are configured to each have four signal routes in the delay control device 100 of the present embodiment, this is notmeant to be restrictive, and these parts can be configured to each have two or more signal routes. Also, it is not necessarily required to have the same number of signal routes included in each of the first signal route part 110 and the second signal route part 120. As the number of combinations of a signal route of the first signal route part 110 and a signal route of the second signal route part 120 increases, the relative delay time between the first output pulse signal 13 and the second output pulse signal 14 can be further finely selected.

### (Second Embodiment)

A delay control device according to a second embodiment of the present invention is described below using FIG. 4. FIG. 4 is a block diagram showing the structure of a delay control device 200 of the present embodiment. In place of the first output side switch 131 and the second output side switch 132 included in the delay control device 100 of the first embodiment, the delay control device 200 of the present embodiment includes a first input side switch 233 and a second input side switch 234. With this, the first input pulse signal 11 is outputted via any one of the four signal routes 111 to 114 of the first signal route part 110 selected by the first input side switch 233 to the first output end 103. Similarly, the second input pulse signal 12 is outputted via any one of the four signal routes 121 to 124 of the second signal route part 120 selected by the second input side switch 234 to the second output end 104.

Also in the present embodiment, the signal routes 111 to 114 each have 0, two, four, and six NOT gates 107, respectively, cascade-connected to each other and, similarly, the signal routes 121 to 124 each have 0, two, four, and six NOT gates 107, respectively, cascade-connected to each other. With this, by combining a selection by the first input side switch 233 and a selection by the second input side switch 234, sixteen different delay times can be provided also in the delay control device 200 of the present embodiment. As a result, as with the delay control device 100 of the first embodiment, a value near the target value of the delay time can be selected. Also, by achieving the delay control device 200 of the present embodiment by using a PLD, the device can be miniaturized to decrease cost.

### (Third Embodiment)

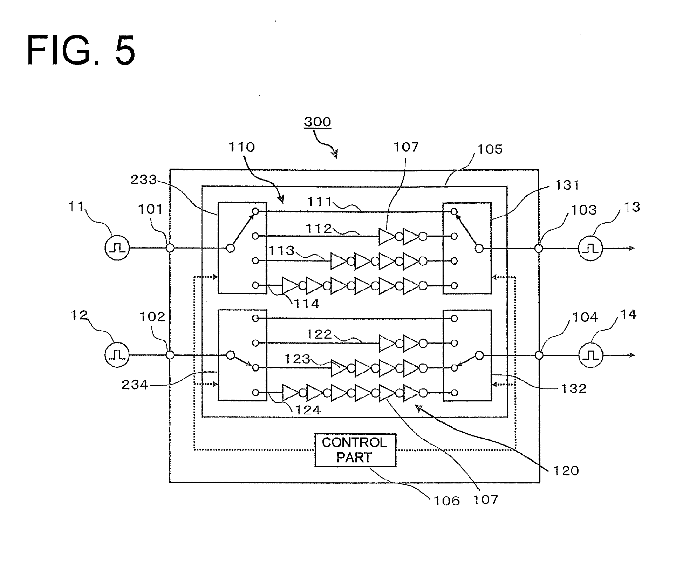

A delay control device according to a third embodiment of the present invention is described below using FIG. 5. FIG. 5 is a block diagram showing the structure of a delay control device 300 of the present embodiment. The delay control device 300 of the present embodiment includes both of the first output side switch 131 and the second output side switch 132 included in the delay control device 100 of the first embodiment and the first input side switch 233 and the second input side switch 234 included in the delay control device 200 of the second embodiment. In the present embodiment, the control part 106 performs control so that the same signal route is selected by the input side switch 233 and the output side switch 131 and the input side switch 234 and the output side switch 132.

With the structure as described above, the first input pulse signal 11 is transmitted via any one of the four signal routes 111 to 114 of the first signal route part 110 selected by the first input side switch 233 to the first output side switch 131. Also at the first output side switch 131, the same signal route selected by the first input side switch 233 is selected. The first input pulse signal 11 passes through the first output side switch 131 for output to the first output end 103. Similarly, the second input pulse signal 12 is also outputted via any one of the four signal routes 121 to 124 of the second signal route part 120 selected by the second input side switch 234 and the second output side switch 132 to the second output end 104.

Also in the present embodiment, the signal routes 111 to 114 each have 0, two, four, and six NOT gates 107, respectively, cascade-connected to each other and, similarly, the signal routes 121 to 124 each have 0, two, four, and six NOT gates 107, respectively, cascade-connected to each other. With this, by combining a selection by the first input side switch 233 and the first output side switch 131 and a selection by the second input side switch 234 and the second output side switch 132, sixteen different delay times can be provided also in the delay control device 300 of the present embodiment. As a result, as with the delay control device 100 of the first embodiment, a value near the target value of the delay time can be selected. Also, by achieving the delay control device 300 of the present embodiment by using a PLD, the device can be miniaturized to decrease cost.

### (Fourth Embodiment)

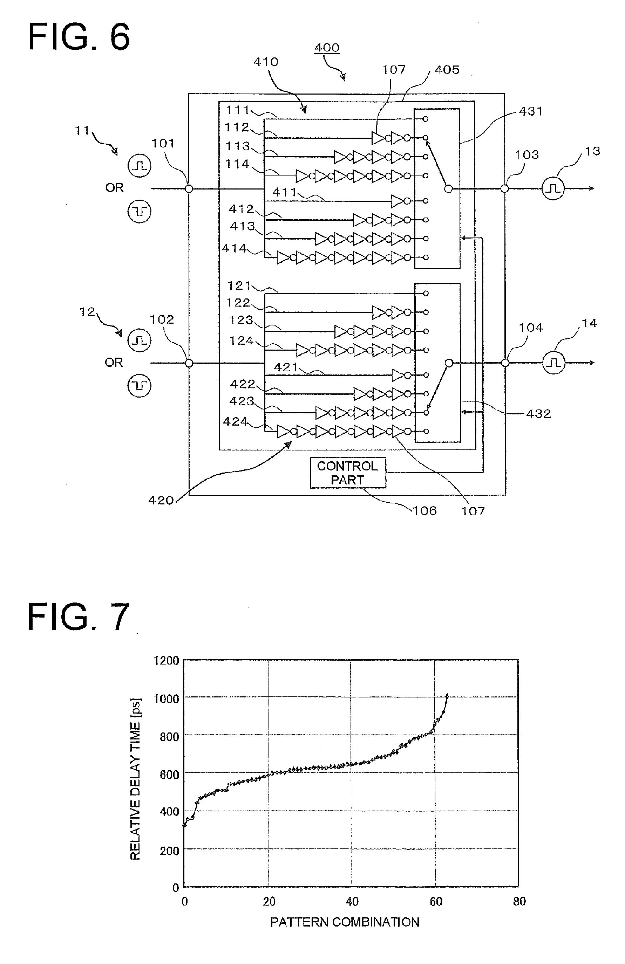

A delay control device according to a fourth embodiment of the present invention is described below using FIG. 6. FIG. 6 is a block diagram showing the structure of a delay control device 400 of the present embodiment. In place of the delay control circuit 105 for use in the first embodiment, a delay control circuit 405 having a different structure is used in the delay control device 400 of the present embodiment. That is, the structure of a first signal route part 410, a second signal route part 420, a first output side switch 431, and a second output side switch 432 included in the a delay control circuit 405 of the present embodiment is different from that of the first signal route part 110, the second signal route part 120, the first output side switch 131, and the second output side switch 132 used in the first embodiment.

In the first to third embodiments, the signal routes 111 to 114 and the signal routes 121 to 124 each have 0 or an even number of NOT gates 107 cascade-connected to each other. As such, since the number of NOT gates 107 for connection is restricted to an even number, the number of signal routes having different numbers of NOT gates 107 in the first signal route part 110 and the second signal route part 120 is restricted. In each of the embodiments described above, four signal routes are provided in each of the first signal route part 110 and the second signal route part 120, and the number of combinations of selections of signal routes is sixteen. To further increase the number of combinations in each of the embodiments described above, it is required to increase the number of signal routes and further add two more NOT gates 107 for each signal routes to be added for cascade connection, thereby significantly increasing the number of NOT gates 107. For this reason, if the number of NOT gates 107 cannot be significantly increased, the number of signal routes is restricted.

To get around this, the delay control device 400 of the present embodiment is configured so that an odd number of NOT gates 107 can be connected in one signal route. However, an inverted input pulse signal passes through the signal route where an odd number of NOT gates 107 are cascade-connected to each other. In the present embodiment, a non-inversion signal and an inversion signal are both used.

The first signal route part 410 for use in the present embodiment has, in addition to a first sub signal route part formed of the signal routes 111 to 114 having even numbers, that is, 0, two, four, and six, respectively, of NOT gates 107 cascade-connected to each other, a second sub signal route part formed of signal routes 411 to 414 having odd numbers, that is, one, three, five, and seven, respectively, of NOT gates 107 cascade-connected to each other. With this, the first signal route part 410 has eight signal routes having different numbers of NOT gates 107 cascade-connected to each other. Similarly, the second signal route part 420 has a third sub signal route part formed of the signal routes 121 to 124 having even numbers, that is, 0, two, four, and six, respectively, of NOT gates 107 cascade-connected to each other and a fourth sub signal route part formed of signal routes 421 to 424 having odd numbers, that is, one, three, five, and seven, respectively, of NOT gates 107 cascade-connected to each other, and thus has eight signal routes having different numbers of NOT gates 107.

Correspondingly to the first signal route part 410 and the second signal route part 420 configured to each have eight signal routes, the first output side switch 431 and the second output side switch 432 also each have eight terminals.

In the present embodiment, as the first input pulse signal 11 and the second input pulse signal 12, a non-inversion signal or an inversion signal is inputted to the first input end 101 and the second input end 102. Therefore, the control part 106 changes the control over the first output side switch 431 and the second output side switch 432 depending on whether the input pulse signal is a non-inversion signal or an inversion signal. That is, the control part 106 performs control so that the first output side switch 431 is connected to any one of the signal routes 111 to 114 of the first sub signal route part when the first input pulse signal 11 is a non-inversion signal. Also, when the first input pulse signal 11 is an inversion signal, the control part 106 performs control so that the first output side switch 431 is connected to any one of the signal routes 411 to 414 of the second sub signal route part. Similarly, the control part 106 performs control so that the second output side switch 432 is connected to any one of the signal routes 121 to 124 of the third sub signal route part when the second input pulse signal 12 is a non-inversion signal. Also, when the second input pulse signal 12 is an inversion signal, the control part 106 performs control so that the second output side switch 432 is connected to any one of the signal routes 421 to 424 of the fourth sub signal route part.

The delay control device 400 of the present embodiment is configured to include, as shown in FIG. 6, the first signal route part 410 having the eight signal routes 111 to 114 and 411 to 414 and the second signal route part 420 having the eight signal routes 121 to 124 and 421 to 424. With this, the number of combinations of signal routes selectable by the first output side switch 431 and the second output side switch 432 is 8x8=64. As such, in the present embodiment, the number of combinations of signal routes can be significantly increased, compared with sixteen in the first to third embodiments.

An example of relative delay times each between the first output pulse signal 13 and the second output pulse signal 14 with respect to each combination of a signal route of the first signal route part 410 and a signal route of the second signal route part 420 is shown in Table 2.

**Table 2**

| Route combination No. | Relative delay [ps] | Route combination No. | Relative delay [ps] |
|---|---|---|---|
| 1 | 322 | 33 | 625.8 |
| 2 | 351 | 34 | 626 |
| 3 | 362 | 35 | 627 |
| 4 | 440.7 | 36 | 628.4 |
| 5 | 466 | 37 | 630 |
| 6 | 475.6 | 38 | 630.5 |
| 7 | 488 | 39 | 637.72 |
| 8 | 492 | 40 | 640.541 |
| 9 | 506.4 | 41 | 643 |
| 10 | 507 | 42 | 644.7 |
| 11 | 507.2 | 43 | 645.3 |
| 12 | 539.25 | 44 | 654.4 |
| 13 | 541.1 | 45 | 655 |
| 14 | 549 | 46 | 668.1 |
| 15 | 554.6 | 47 | 680.8 |
| 16 | 556.2 | 48 | 682 |
| 17 | 561 | 49 | 683 |
| 18 | 564 | 50 | 692 |
| 19 | 570.85 | 51 | 708.7 |
| 20 | 580.6 | 52 | 711.8 |
| 21 | 588.2 | 53 | 743.6 |
| 22 | 595.341 | 54 | 745.4 |
| 23 | 598 | 55 | 765 |
| 24 | 598.5 | 56 | 781 |
| 25 | 600.59 | 57 | 784 |
| 26 | 613.7 | 58 | 792.4 |
| 27 | 615 | 59 | 802 |
| 28 | 616.7 | 60 | 816.5 |
| 29 | 617.02 | 61 | 857 |
| 30 | 619.6 | 62 | 879 |
| 31 | 621.1 | 63 | 923 |
| 32 | 624.8 | 64 | 1007 |

Also, FIG. 7 shows the results shown in Table 2 plotted in the order in which the combination with the shortest delay time comes first. Compared with the delay time achieved in the delay control device 100 of the first embodiment shown in FIG. 3, it is possible to further finely achieve a delay time in the delay control device 400 of the present embodiment as shown in FIG. 7. By using the delay control device 400 of the present embodiment for, for example, a pulse radar device, a desired delay time can be accurately achieved and, for example, a distance to the target object can be measured with high accuracy.

Also, while further more NOT gates 107 are used in the delay control device 400 of the present embodiment compared with the first to third embodiments, the device can be achieved also by using a PLD. With the use of a PLD, the delay control device 400 can be miniaturized to decrease cost.

### (Fifth Embodiment)

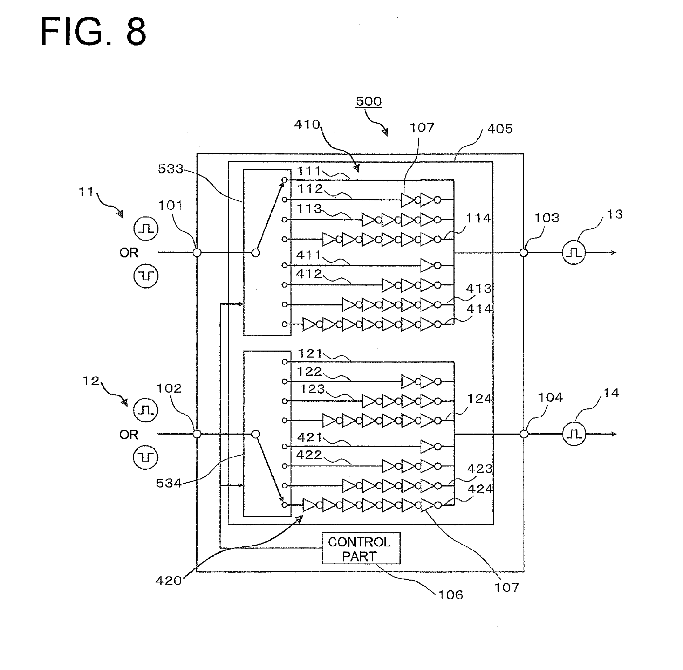

A delay control device according to a fifth embodiment of the present invention is described below using FIG. 8. FIG. 8 is a block diagram showing the structure of a delay control device 500 of the present embodiment. In place of the first output side switch 431 and the second output side switch 432 included in the delay control device 400 of the fourth embodiment, the delay control device 500 of the present embodiment includes a first input side switch 533 and a second input side switch 534. Among the eight signal routes of the first signal route part 410, the first input side switch 533 selects any one of the signal routes 111 to 114 of the first sub signal route part when the first input pulse signal 11 is a non-inversion signal, and selects any one of the signal routes 411 to 414 of the second sub signal route part when the first input pulse signal 11 is an inversion signal. The first input pulse signal 11 is outputted from the first input terminal 101 via the signal route in the first signal route part 410 selected by the first input side switch 533 to the first output end 103.

Similarly, among the eight signal routes of the second signal route part 420, the second input side switch 534 selects any one of the signal routes 121 to 124 of the third sub signal route part when the second input pulse signal 12 is a non-inversion signal, and selects any one of the signal routes 421 to 424 of the fourth sub signal route part when the second input pulse signal 12 is an inversion signal. The second input pulse signal 12 is outputted from the second input terminal 102 via the signal route in the second signal route part 420 selected by the second input side switch 534 to the second output end 104.

Also in the present embodiment, the first signal route part 410 and the second signal route part 420 each have eight signal routes each having any number of 0 to seven NOT gates 107. By combining the selection by the first input side switch 533 and the selection by the second input side switch 534, sixty-four different delay times can be provided also in the delay control device 500 of the present embodiment. As a result, as with the delay control device 400 of the fourth embodiment, the delay time can be further finely achieved. Furthermore, by achieving the delay control device 500 of the present embodiment by using a PLD, the device can be miniaturized to decrease cost.

### (Sixth Embodiment)

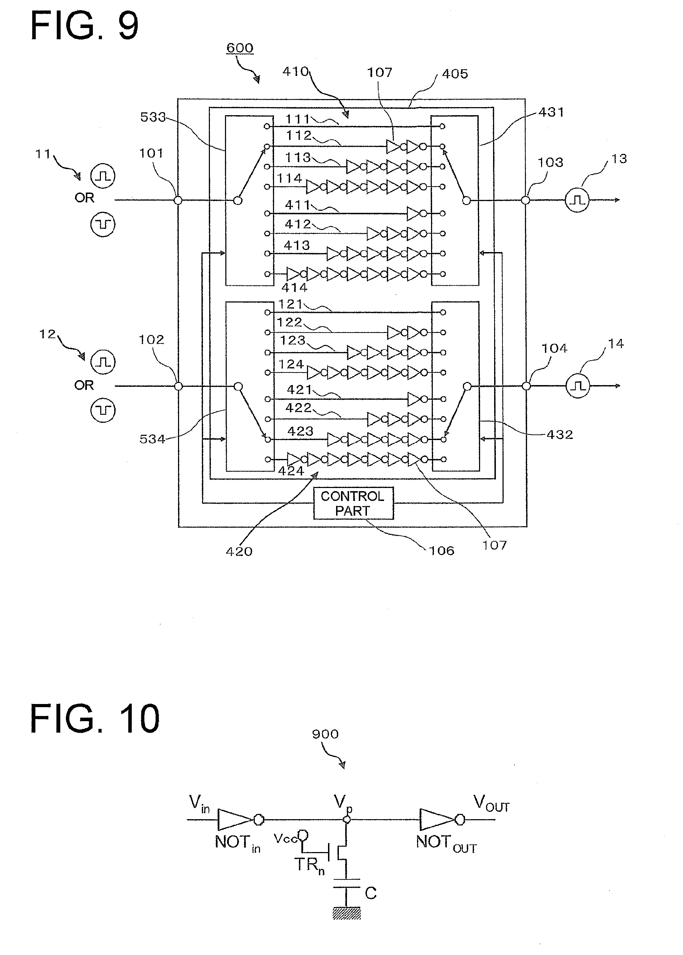

A delay control device according to a sixth embodiment of the present invention is described below using FIG. 9. FIG. 9 is a block diagram showing the structure of a delay control device 600 of the present embodiment. The delay control device 600 of the present embodiment includes both of the first output side switch 431 and the second output side switch 432 included in the delay control device 400 of the fourth embodiment and the first input side switch 533 and the second input side switch 534 included in the delay control device 500 of the fifth embodiment. In the present embodiment, the control part 106 performs control so that the input side switch and the output side switch select the same route.

With the structure as described above, the first input pulse signal 11 is transmitted via any one of the eight signal routes 111 to 114 and 411 to 414 of the first signal route part 410 selected by the first input side switch 533 to the first output side switch 431. The same signal route selected by the first input side switch 533 is selected by the first output side switch 431, and the first input pulse signal 11 passes through the first output side switch 431 for output to the first output end 103. Similarly, the second input pulse signal 12 is also outputted via any one of the eight signal routes 121 to 124 and 421 to 424 of the second signal route part 420 selected by the second input side switch 534 and the second output side switch 432 to the second output end 104.

Also in the present embodiment, the first signal route part 410 and the second signal route part 420 each have eight signal routes each having any number of 0 to seven NOT gates 107. And, by combining the selection by the first input side switch 533 and the first output side switch 431 and the selection by the second input side switch 534 and the second output side switch 432, sixty-four different delay times can be provided also in the delay control device 600 of the present embodiment. As a result, as with the delay control device 400 of the fourth embodiment, the delay time can be further finely achieved. Furthermore, by achieving the delay control device 600 of the present embodiment by using a PLD, the device can be miniaturized to decrease cost.

Note that description has been made in the first to sixth embodiments to a case (A) in which the first signal route 110 and the second signal route part 120 each have a plurality of signal routes each having a different number, which is 0 or an even number, of NOT gates cascade-connected to each other (the first to third embodiments) and a case (B) in which the first signal route part 410 and the second signal route part 420 each have both of a sub signal route part (the first and third sub signal route parts) formed of a plurality of signal routes each having a different number, which is 0 or an even number, of NOT gates cascade-connected to each other and a sub signal route part (the second and fourth sub signal route parts) formed of a plurality of signal routes each having a different odd number of NOT gates cascade-connected to each other (the fourth to sixth embodiments). However, the present invention is not restricted to this, and can be applied to a case (C) either one of the first signal route part and the second signal part has only ones of a plurality of signal routes each having a different number, which is 0 or an even number, of NOT gates cascade-connected to each other and a plurality of signal routes each having a different odd number of NOT gates cascade-connected to each other and the other one has both of a sub signal route part (the first or third sub signal route part) formed of a plurality of signal routes each having a different number, which is 0 or an even number, of NOT gates cascade-connected to each other and a sub signal route part (the second or fourth sub signal route part) formed of a plurality of signal routes each having a different odd number of NOT gates cascade-connected to each other (the second or fourth sub signal route part) and a case (D) either one of the first signal route part and the second signal route part has either one of the first and third sub signal route parts and either one of the second and fourth sub signal route parts and the other one of the first signal route part and the second signal route part has the other one of the first and third sub signal route parts and the other one of the second and fourth sub signal route parts.

Also, while the number of NOT gates provided in each signal route in each of the first signal route part and the second signal route part varies in the first to sixth embodiments, if the delay time of each signal route varies due to, for example, an influence such as a wiring position formed in the PLD, some signal routes may have the same number of NOT gates. Furthermore, if the delay time of each signal route varies due to, for example, an influence such as a wiring position formed in the PLD, a NOT gate is not necessarily used.

### (Seventh Embodiment)

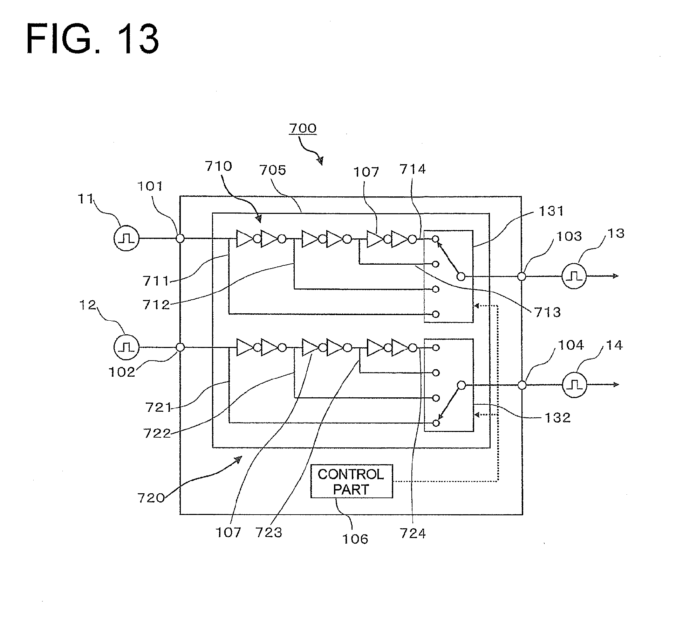

A delay control device according to a seventh embodiment of the present invention is described below using FIG. 13. FIG. 13 is a block diagram showing the structure of a delay control device 700 of the present embodiment. The delay control device 700 of the present embodiment is configured to achieve a delay time to the same degree as that of the delay control device 100 of the first embodiment by using a small number of NOT gates 107. In the delay control device 100 of the first embodiment, the first signal route part 110 and the second signal route part 120 each have four signal routes, and the signal routes have 0, two, four, and six (each has a different number, which is 0 or an even number, of) NOT gates 107, respectively, cascade-connected to each other. With this, the first signal route part 110 and the second signal route part 120 each require twelve NOT gates 107.

By contrast, in the delay control device 700 of the present embodiment, a first signal route part 710 and a second signal route part 720 are each configured by using six NOT gates 107. In the first signal route part 710, six NOT gates 107 are cascade-connected to each other to form a signal route 714, and the signal route 714 is branched midway to signal routes 711 to 713. That is, after inputted from the first input terminal 101 and before passing through the NOT gates 107, the signal route 711 is branched from the signal route 714 to be connected to the first output side switch 131. Also, a signal route 712 is branched from the signal route 714 at a point after passing through two NOT gates 107 to be connected to the first output side switch 131. Furthermore, a signal route 713 is branched from the signal route 714 at a point after passing four NOT gates 107 to be connected to the first output side switch 131.

As described above, by forming the signal route 714 having six NOT gates 107 cascade-connected to each other and the signal routes 711 to 713 obtained by branching midway from the signal route 714, as with the delay control device 100 of the first embodiment, the first signal route part 710 having the signal routes 711 to 714 passing through 0, two, four, and six NOT gates 107, respectively, can be formed. The second signal route part 720 can has a similar structure. With this, the delay control device 700 of the present embodiment can achieve a relative delay time between the first output pulse signal 13 and the second output pulse signal 14 to the same degree as that of the first embodiment by using half of the NOT gates 107 of the delay control device 100 of the first embodiment. Note that the first signal route part 710 and the second signal route part 720 of the present embodiment can be applied to the structure of the second embodiment. That is, the first input side switch 233 and the second input side switch 234 are provided as in the second embodiment, and the signal route 714 (a signal route 724) having six NOT gates 107 cascade-connected to each other is disposed between one terminal of one connection end of the first input side switch 233 (the second input side switch 234) and the first output end 103 (the second output end 104). Also, the signal route outputted from the other terminal of the one connection end of the first input side switch 233 (the second input side switch 234) is merged to the signal route 714 (the signal route 724) at a point after passing through two NOT gates, a point after passing through four NOT gates, and a point after passing through sixth NOT gates on the signal route 714 (the signal route 724).

### (Eighth Embodiment)

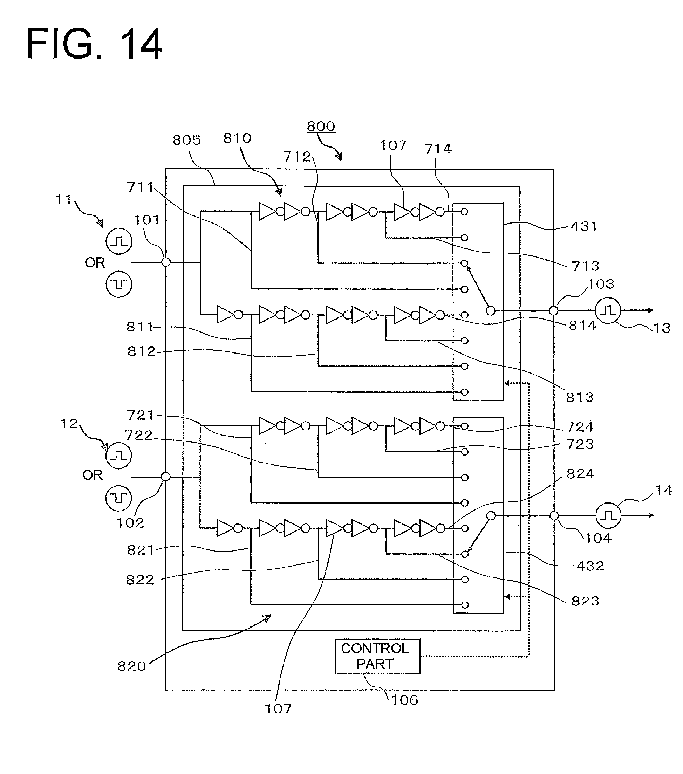

A delay control device according to an eighth embodiment of the present invention is described below using FIG. 14. FIG. 14 is a block diagram showing the structure of a delay control device 800 of the present embodiment. The delay control device 800 of the present embodiment is configured so as to achieve a delay time to the same degree as that of the delay control device 400 of the fourth embodiment by using a small number of NOT gates 107. A first signal route part 810 of the present embodiment has a first sub signal route part in which the signal routes 711 to 714 similar to those of the first signal route part 710 of the seventh embodiment are formed by using six NOT gates 107 and a second sub signal route part formed of signal routes 811 to 814 by using seven NOT gates 107.

The second sub signal route part of the first signal route part 810 forms a signal route 814 with seven NOT gates 107 cascade-connected to each other, and the signal route 814 is branched midway to signal routes 811 to 813. That is, the signal route 811 comes after being inputted from the first input end 101 and branched from the signal route 814 at a point after passing through one NOT gate 107, and is then connected to the first output side switch 431. Also, the signal route 812 comes after being branched from the signal route 814 at a point after passing through three NOT gates 107, and is then connected to the first output side switch 431. Furthermore, the signal route 813 comes after being branched from the signal route 814 at a point after passing through five NOT gates 107, and is then connected to the first output side switch 431.

As with the first sub signal route part, by forming the signal route 814 having seven NOT gates 107 cascade-connected to each other and the signal routes 811 to 813 by branching midway the signal route 814, a second sub signal route part of the first signal route part 810 having the signal routes 811 to 814 passing through one, three, five, and seven NOT gates 107, respectively, can be formed. A second signal route part 820 is assumed to have a similar structure. With this, the delay control device 800 of the present embodiment can achieve a relative delay time between the first output pulse signal 13 and the second output pulse signal 14 to the same degree as that of the fourth embodiment by using half of the NOT gates 107 or less of the delay control device 400 of the fourth embodiment.

Note that the first signal route part 810 and the second signal route part 820 of the present embodiment can be applied to the structure (FIG. 8) of the fifth embodiment. That is, as with the fifth embodiment, the first input side switch 533 and the second input side switch 534 are provided. Then, for the first signal route part 810, the signal route 714 having six NOT gates 107 cascade-connected between one terminal of one connection end of the first input side switch 533 and the first output end 103 is disposed. Also, a signal route from the other terminal of the one connection end of the first input side switch 533 is merged to the signal route 714 at a point passing through two NOT gates, a point passing through four NOT gates, and a point passing through six NOT gates on the signal route 714. Furthermore, the signal route 814 having seven NOT gates 107 cascade-connected to each other between the other one terminal of the one connection end of the first input side switch 533 and the first output end 103 is disposed. Still further, a signal route from the other terminal of the one connection end of the first input side switch 533 is merged to the signal route 814 at a point passing through two NOT gates, a point passing through four NOT gates, and a point passing through six NOT gates on the signal route 814. Still further, also for the second signal route part 820, similarly, the signal route 724 having six NOT gates 107 cascade-connected to each other and a signal route 824 having seven NOT gates 107 cascade-connected to each other are disposed between the second input side switch 534 and the second output end 104 for configuration.

### (Ninth Embodiment)

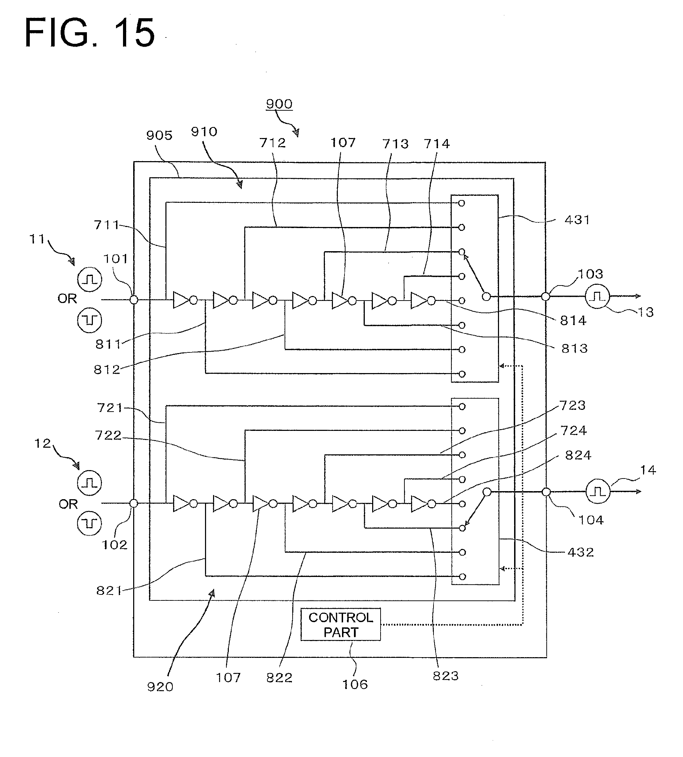

A delay control device according to a ninth embodiment of the present invention is described below using FIG. 15. FIG. 15 is a block diagram showing the structure of a delay control device 900 of the present embodiment. The delay control device 900 of the present embodiment is configured so as to achieve a delay time to the same degree as that of the delay control device 400 of the fourth embodiment by using a smaller number of NOT gates 107 than those of the eighth embodiment. In the present embodiment, the signal route 814 (the first main signal route) is configured with a plurality of (seven in the present embodiment) NOT gates 107 cascade-connected to each other. Then, the signal route is branched before entering odd-numbered NOT gates, that is, the first, third, fifth, and seventh NOT gates 107, of these seven NOT gates to configure the signal routes 711, 712, 713, and 714. Also, the signal route is branched before entering even-numbered NOT gates, that is, the second, fourth, and sixth NOT gates 107, to configure the signal routes 811, 812, and 813. The signal routes 711, 712, 713, and 714 each pass through a different number, which is 0 or an even number (0, two, four, and six, respectively), of NOT gates 7 to configure the first sub signal route part. Also, the signal routes 811, 812, 813, and 814 each pass through a different odd number (one, three, five, and seven, respectively) of NOT gates 107 to configure the second sub signal route part. Also a second signal route part 920 is configured similarly by branching the signal route 824 (the second main signal route) having a plurality of NOT gates 107 cascade-connected to each other.

The control device 900 of the present embodiment can achieve a relative delay time between the first output pulse signal 13 and the second output pulse signal 14 to the same degree as that of the fourth embodiment by using further less NOT gates 107 than those of the delay control device 800 of the eighth embodiment. Note that the first signal route part 910 and the second signal route part 920 of the present embodiment can also be applied to the structure of the fifth embodiment. That is, as with the fifth embodiment, the first input side switch 533 and the second input side switch 534 can also be connected to input sides of the first signal route part 910 and the second signal route part 920, respectively.

The description of the embodiments each merely show an example of the delay control device according to the present invention, and the present invention is not restricted to these embodiments. Detailed structure, detailed operations, and others of the delay control device in each embodiment can be changed as appropriate in a range not deviating from the gist of the present invention.

### Reference Numerals

1: Computing device
11: First input pulse signal
12: Second input pulse signal
13: First output pulse signal
14: Second output pulse signal
100, 200, 300, 400, 500, 600, 700, 800, 900: Delay control device
101: First input end
102: Second input end
103: First output end
104: Second output end
105, 405, 705, 805, 905: Delay control circuit
106: Control part
107: NOT gate
110, 410, 710, 810, 910: First signal route part
111 to 114, 121 to 124, 411 to 414, 421 to 424, 721 to 724, 821 to 824: Signal route
120, 420, 720, 820, 920: Second signal route part
131, 431: First output side switch
132, 432: Second output side switch
233, 533: First input side switch
234, 534: Second input side switch

## Claims

1. A delay control device that receiving inputs of a first input pulse signal and a second input pulse signal and outputting a first output pulse signal and a second output pulse signal having a relative delay time near a predetermined target value, the device comprising:
a first input end receiving the input of the first input pulse signal;
a second input end receiving the input of the second input pulse signal;
a first output end outputting the first output pulse signal;
a second output end outputting the second output pulse signal;
a first signal route part having two or more signal routes with different delay times;
a second signal route part having two or more signal routes with different delay times;
a first switch having one connection end formed of two or more terminals connecting one end of each of two or more signal routes of the first signal route part and another connection end formed of one terminal;
a second switch having one connection end formed of two or more terminals connecting one end of each of two or more signal routes of the second signal route part and another connection end formed of one terminal; and
a control part outputting a control signal to the first switch and the second switch so that a relative delay time between the first output pulse signal and the second output pulse signal is near the target value, the control signal for selecting any one of the terminals of the one connection end of the first switch and connecting the selected terminal to the terminal of the other connection end of the first switch and for selecting any one of the terminals of the one connection end of the second switch and connecting the selected terminal to the terminal of the other connection end of the second switch, wherein
the first signal route part and the first switch are connected between the first input end and the first output end, and
the second signal route part and the second switch are connected between the second input end and the second output end.

2. The delay control device according to claim 1, wherein
the signal routes of the first signal route part and/or the second signal route part are configured so that the delay times are different among the signal routes by providing 0 or one or more NOT gates cascade-connected to each other on the signal routes.

3. The delay control device according to claim 2, wherein
the control part
connects the first switch to one of signal routes passing through 0 or an even number of NOT gates or one of signal routes passing through an odd number of NOT gates in the first signal route part according to whether the first input pulse signal is a non-inversion signal or an inversion signal, and connects the second switch to one of signal routes passing through 0 or an even number of NOT gates or one of signal routes passing through an odd number of NOT gates in the second signal route part according to whether the second input pulse signal is a non-inversion signal or an inversion signal.

4. The delay control device according to any one of claims 1 to 3, wherein
two or more signal routes of the first signal route part each have an output side connected to the one connection end of the first switch and an input side merged to be connected to the first input end,
the other connection end of the first switch is connected to the first output end,
two or more signal routes of the second signal route part each have an output side connected to the one connection end of the second switch and an input side merged to be connected to the second input end, and
the other connection end of the second switch is connected to the second output end.

5. The delay control device according to any one of claims 1 to 3, wherein
the other connection end of the first switch is connected to the first input end,
two or more signal routes of the first signal route part each have an input side connected to the one connection end of the first switch and an output side merged to be connected to the first output end,
the other connection end of the second switch is connected to the second input end, and
two or more signal routes of the second signal route part each have an input side connected to the one connection end of the second switch and an output side merged to be connected to the second output end.

6. The delay control device according to any one of claims 1 to 3, wherein
two said first switches and two said second switches are provided and connected to an input side and an output side of the first signal route part and an input side and an output side of the second signal route part,
the other connection end of the first switch connected to the input side of the first signal route part is connected to the first input end and the other connection end of the first switch connected to the output side of the first signal route part is connected to the first output end, and
the other connection end of the second switch connected to the input side of the second signal route part is connected to the second input end and the other connection end of the second switch connected to the output side of the second signal route part is connected to the second output end.

7. The delay control device according to any one of claims 1 to 6, wherein
the first input pulse signal is a non-inversion signal, and
the first signal route part is configured so that the two or more signal routes each pass through a different number, which is 0 or an even number, of NOT gates.

8. The delay control device according to any one of claims 1 to 6, wherein
the first input pulse signal is an inversion signal, and
the first signal route part is configured so that the two or more signal routes each pass through a different odd number of NOT gates.

9. The delay control device according to any one of claims 1 to 6, wherein
the first input pulse signal is an non-inversion signal or an inversion signal,
the first signal route part has a first sub signal route part formed of two or more signal routes each passing through a different number, which is 0 or an even number, of NOT gates and a second sub signal route part formed of two or more signal routes each passing through a different odd number of NOT gates, and
the control part outputs a control signal for selecting one of the signal routes in the first sub signal route part to the first switch when the first input pulse signal is a non-inversion signal, and outputs a control signal for selecting one of the signal routes in the second sub signal route part to the first switch when the first input pulse signal is an inversion signal.

10. The delay control device according to any one of claims 1 to 9 wherein
the second input pulse signal is a non-inversion signal, and
the second signal route part is configured so that the two or more signal routes each pass through a different number, which is 0 or an even number, of NOT gates.

11. The delay control device according to any one of claims 1 to 9, wherein
the second input pulse signal is an inversion signal, and
the second signal route part is configured so that the two or more signal routes each pass through a different odd number of NOT gates.

12. The delay control device according to any one of claims 1 to 9, wherein
the second input pulse signal is an non-inversion signal or an inversion signal,
the second signal route part has a third sub signal route part formed of two or more signal routes passing through a different number, which is 0 or an even number, NOT gates and a fourth sub signal route part formed of two or more signal routes each passing through a different odd number of NOT gates, and
the control part outputs a control signal for selecting one of the signal routes in the third sub signal route part to the second switch when the second input pulse signal is a non-inversion signal, and outputs a control signal for selecting one of the signal routes in the fourth sub signal route part to the second switch when the second input pulse signal is an inversion signal.

13. The delay control device according to any one of claims 1 to 3, wherein
the first input pulse signal is a non-inversion signal, and
the first signal route part has
a first main signal route having N₁ (N₁ is an even number equal to or larger than 2) NOT gates cascade-connected to each other and
a branch signal route branched from the first main signal route immediately before an M₁-th (M₁=1, 3, ..., N₁-1) NOT gate of the N₁ NOT gates or a branch signal route merged to the first main signal route immediately after an L₁-th (L₁=2, 4, ..., N₁) NOT gate of the N₁ NOT gates.

14. The delay control device according to any one of claims 1 to 3, wherein
the first input pulse signal is an inversion signal, and
the first signal route part has
a second main signal route having N₂ (N₂ is an odd number equal to or larger than 3) NOT gates cascade-connected to each other and
a branch signal route branched from the second main signal route immediately after an M₂-th (M₂=1, 3, ..., N₂-2) NOT gate of the N₂ NOT gates or a branch signal route merged to the second main signal route immediately after an L₂-th (L₂=2, 4, ..., N₂-1) NOT gate of the N₂ NOT gates.

15. The delay control device according to any one of claims 1 to 3, wherein
the first input pulse signal is a non-inversion signal or an inversion signal,
the first signal route part has
(1) a first sub signal route part having a first main signal route having N₁ (N₁ is an even number equal to or larger than 2) NOT gates cascade-connected to each other, and a branch signal route branched from the first main signal route immediately before an M₁-th (M₁=1, 3, ..., N₁-1) NOT gate of the N₁ NOT gates or a branch signal route merged to the first main signal route immediately after an L₁-th (L₁=2, 4, ..., N₁) NOT gate of the N₁ NOT gates and
(2) a second sub signal route part having a second main signal route having N₂ (N₂ is an odd number equal to or larger than 3) NOT gates cascade-connected to each other, and a branch signal route branched from the second main signal route immediately after an M₂-th (M₂=1, 3, ..., N₂-2) NOT gate of the N₂ NOT gates or a branch signal route merged to the second main signal route immediately after an L₂-th (L₂=2, 4, ..., N₂-1) NOT gate of the N₂ NOT gates, and
the control part outputs a control signal for selecting one of the signal routes in the first sub signal route part to the first switch when the first input pulse signal is a non-inversion signal, and outputs a control signal for selecting one of the signal routes in the second sub signal route part to the first switch when the first input pulse signal is an inversion signal.

16. The delay control device according to any one of claims 1 to 3 and 13 to 15, wherein
the second input pulse signal is a non-inversion signal, and
the second signal route part has
a third main signal route having N₃ (N₃ is an even number equal to or larger than 2) NOT gates cascade-connected to each other, and
a branch signal route branched from the third main signal route immediately before an M₃-th (M₃=1, 3, ..., N₃-1) NOT gate of the N₃ NOT gates or a branch signal route merged to the third main signal route immediately after an L₃-th (L₃=2, 4, ..., N₃) NOT gate of the N₃ NOT gates.

17. The delay control device according to any one of claims 1 to 3 and 13 to 15, wherein
the second input pulse signal is an inversion signal, and
the second signal route part has
a fourth main signal route having N₄ (N₄ is an odd number equal to or larger than 3) NOT gates cascade-connected to each other, and
a branch signal route branched from the fourth main signal route immediately after an M₄-th (M₄=1, 3, ... , N₄-2) NOT gate of the N₄ NOT gates or a branch signal route merged to the fourth main signal route immediately after an L₄-th (L₄=2, 4, ..., N₄-1) NOT gate of the N₄ NOT gates.

18. The delay control device according to any one of claims 1 to 3 and 13 to 15, wherein
the second input pulse signal is a non-inversion signal or an inversion signal,
the second signal route part has
(1) a third sub signal route part having a third main signal route having N₃ (N₃ is an even number equal to or larger than 2) NOT gates cascade-connected to each other, and a branch signal route branched from the third main signal route immediately before an M₃-th (M₃=1, 3, ..., N₃-1) NOT gate of the N₃ NOT gates or a branch signal route merged to the third main signal route immediately after an L₃-th (L₃=2, 4, ..., N₃) NOT gate of the N₃ NOT gates and
(2) a fourth sub signal route part having a fourth main signal route having N₄ (N₄ is an odd number equal to or larger than 3) NOT gates cascade-connected to each other, and a branch signal route branched from the fourth main signal route immediately after an M₄-th (M₄=1, 3, ..., N₄-2) NOT gate of the N₄ NOT gates or a branch signal route merged to the fourth main signal route immediately after an L₄-th (L₄=2, 4, ..., N₄-1) NOT gate of the N₄ NOT gates, and
the control part outputs a control signal for selecting one of the signal routes in the third sub signal route part to the second switch when the second input pulse signal is a non-inversion signal, and outputs a control signal for selecting one of the signal routes in the fourth sub signal route part to the second switch when the second input pulse signal is an inversion signal.

19. The delay control device according to any one of claims 1 to 3, wherein
the first input pulse signal is a non-inversion signal or an inversion signal,
the first signal route part has a first main signal route having a plurality of NOT gates cascade-connected to each other and also has
(1) a first sub signal route part formed of a plurality of signal routes each passing through a different even number of NOT gates from an input side of the first main signal route to the one connection end of the first switch by being branched midway from the first main signal route or passing through the entire first main signal route, and a second sub signal route part formed of a plurality of signal routes each passing through a different odd number of NOT gates from the input side of the first main signal route to the one connection end of the first switch by being branched midway from the first main signal route or passing through the entire first main signal route or
(2) a first sub signal route part formed of a plurality of signal routes each passing through a different even number of NOT gates from the one connection end of the first switch to an output side of the first main signal route by being merged midway to the first main signal route or passing through the entire first main signal route, and a second sub signal route part formed of a plurality of signal routes each passing through a different odd number of NOT gates from the one connection end of the first switch to the output side of the first main signal route by being merged midway to the first main signal route or passing through the entire first main signal route, and
the control part outputs a control signal for selecting one of the signal routes in the first sub signal route part to the first switch when the first input pulse signal is a non-inversion signal, and outputs a control signal for selecting one of the signal routes in the second sub signal route part to the first switch when the first input pulse signal is an inversion signal.

20. The delay control device according to any one of claim 1 to 3 and 19, wherein
the second input pulse signal is a non-inversion signal or an inversion signal,
the second signal route part has a second main signal route having a plurality of NOT gates cascade-connected to each other and also has
(1) a third sub signal route part formed of a plurality of signal routes each passing through a different even number of NOT gates from an input side of the second main signal route to the one connection end of the second switch by being branched midway from the second main signal route or passing through the entire second main signal route, and a fourth sub signal route part formed of a plurality of signal routes each passing through a different odd number of NOT gates from the input side of the second main signal route to the one connection end of the second switch by being branched midway from the second main signal route or passing through the entire second main signal route or
(2) a third sub signal route part formed of a plurality of signal routes each passing through a different even number of NOT gates from the one connection end of the second switch to an output side of the second main signal route by being merged midway to the second main signal route or passing through the entire second main signal route, and a fourth sub signal route part formed of a plurality of signal routes each passing through a different odd number of NOT gates from the one connection end of the second switch to the output side of the second main signal route by being merged midway to the second main signal route or passing through the entire second main signal route, and
the control part outputs a control signal for selecting one of the signal routes in the third sub signal route part to the second switch when the second input pulse signal is a non-inversion signal, and outputs a control signal for selecting one of the signal routes in the fourth sub signal route part to the second switch when the second input pulse signal is an inversion signal.

21. The delay control device according to any one of claim 1 to 20, wherein
the first signal route part, the second signal route part, the first switch, and the second switch, and the control part are configured in a PLD (Programmable Logic Device).
